# EUROPEAN PATENT SPECIFICATION

(11) **EP 2 109 123 B1**
(45) Date of publication and mention of the grant of the patent: **17.07.2013**
(21) Application number: 09157661.1
(22) Date of filing: 08.04.2009
(51) Int. Cl.: H01G 4/008, H01F 10/00, H01F 27/34, G11C 11/15

(54) **Apparatus for storing electrical energy**
Vorrichtung zum Speichern von elektrischer Energie
Appareil de stockage d'énergie électrique

(30) Priority: 11.04.2008 US 101309; 23.03.2009 US 409004
(43) Date of publication of application: 14.10.2009
(73) Proprietor: Northern Lights Semiconductor Corp., Saint Paul, MN 55113 (US)
(72) Inventor: Lai, James Chyi, Saint Paul, MN 55113 (US)
(74) Representative: Lang, Christian

(56) References cited:
- EP-A- 1 343 170
- WO-A-2006/003639
- GB-A- 2 445 811
- GB-A- 2 445 812
- JP-A- 7 235 450
- JP-A- 2008 071 720
- US-A- 5 768 181
- US-A1- 2001 007 532
- US-A1- 2003 017 364
- US-A1- 2007 247 784

## Description

### BACKGROUND

### Field of Invention

The present invention relates to an apparatus for storing electrical energy. More particularly, the present invention relates to a magnetic capacitor for storing electrical energy.

### Description of Related Art

Energy storage parts play important roles in our daily life since they influence the performance and the working time of electrical devices. Components such as capacitors used in the circuits and batteries used in portable devices are the most common energy storage parts.

The Giant Magneto Resistance Effect (GMR) is a quantum mechanical effect observed in structures with alternating thin magnetic and thin nonmagnetic sections. The GMR effect shows a significant change in electrical resistance from the zero-field high resistance state to the high-field low resistance state according to an applied external field.

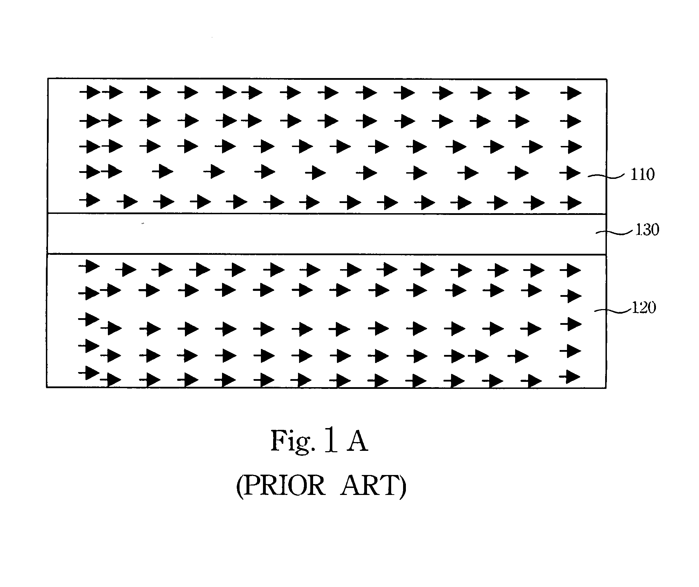

Therefore, the GMR effect can be used as an insulator with good performance. Thus, the apparatus with the GMR effect can be implemented to store electrical energy. A magnetic capacitor is an example of the apparatus with the GMR effect. Magnetic capacitors are formed with magnetic plates. A magnetic plate has a north pole and a south pole, and the north pole and south pole have the strongest magnetic field along the magnetic plate. In reality, the magnetic field strength is summarized and combined with all magnetic dipoles along easy axis. Please refer to Fig. 1A Fig 1A shows localized dipoles of magnetic plates in a magnetic capacitor. The magnetic capacitor includes a first magnetic plate 110, a second magnetic plate 120, and a dielectric layer 130. The first magnetic plate 110 and the second magnetic plate 120 have dipoles pointing to the same directions.

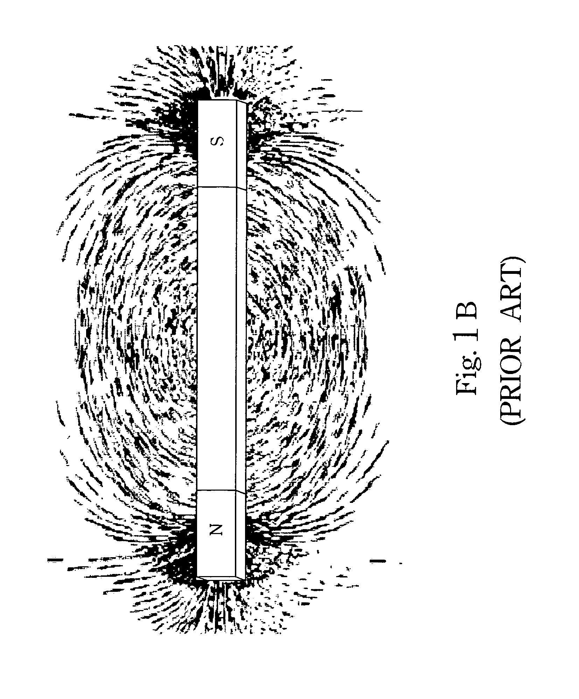

Fig. 1B shows a magnetic plate and the magnetic field contour of the magnetic plate showing the field strength intensity. The density of the magnetic field lines in the magnetic field contour represents the magnetic field strength. As shown in Fig. 1B, the magnetic field strength decreases from two sides of the magnet plate. Due to the magnetic field effect, magnetic capacitors have shown colossal capacitance. Therefore the colossal magnetic effect is reduced from the edge to the center of the magnet plate. However, as the sizes of electrical devices continue to shrink, the need to store more capacitance in a limited area is rising.

A capacitor having a metal-insulator-metal (MIM) construction is disclosed in US2007/0247784A1. Although such capacitors may have already a high capacitance, further increase of capacitance is desirable.

For the foregoing reasons, there is a need to have an apparatus with the GMR effect and large capacitance values to store electrical energy.

### SUMMARY

It is therefore an objective of the present invention to provide an apparatus for storing electrical energy with large capacitance values.

According to one embodiment of the present invention, the apparatus includes a first magnetic layer, a second magnetic layer, and a dielectric layer.

The first magnetic layer includes a first magnetic section and a second magnetic section. The first magnetic section has magnetic dipoles with horizontal directions. The second magnetic section has magnetic dipoles with vertical directions. The second magnetic layer includes a third magnetic section and a fourth magnetic section. The third magnetic section has magnetic dipoles with horizontal directions. The fourth magnetic section has magnetic dipoles with vertical directions. The dielectric layer is configured between the first magnetic layer and the second magnetic layer. The dielectric layer is arranged to store electrical energy. The first magnetic layer and the second magnetic layer are arranged to prevent electrical energy leakage. The vertical magnetic dipoles in the second magnetic section and the fourth magnetic section are designed to increase the capacitance of the apparatus.

According to another embodiment of the present invention, the apparatus includes a first magnetic layer, a second magnetic layer, and a dielectric layer. The first magnetic layer includes a first magnetic section and a second magnetic section. The second magnetic section has magnetic dipoles with vertical directions. The second magnetic layer includes a third magnetic section and a fourth magnetic section. The fourth magnetic section has magnetic dipoles with vertical directions. The dielectric layer is configured between the first magnetic layer and the second magnetic layer. The vertical magnetic dipoles in the second magnetic section and the fourth magnetic section are designed to increase the capacitance of the apparatus.

According to yet another embodiment of the present invention, the apparatus includes a first electrode, a second electrode, and a dielectric layer. The first electrode includes a first conductive section and a second conductive section. The second conductive section has magnetic dipoles with vertical directions. The second electrode includes a third conductive section and a fourth conductive section. The fourth conductive section has magnetic dipoles with vertical directions. The dielectric layer is configured between the first electrode and the second electrode. The vertical magnetic dipoles in the second conductive section and the fourth conductive section are designed to increase the capacitance of the apparatus.

It is to be understood that both the foregoing general description and the following detailed description are by examples, and are intended to provide further explanation of the invention as claimed.

### BRIEF DESCRIPTION OF THE DRAWINGS

These and other features, aspects, and advantages of the present invention will become better understood with regard to the following description, appended claims, and accompanying drawings where:
Fig. 1A shows localized dipoles of magnetic plates in a magnetic capacitor;
Fig. 1B illustrates a magnetic plate and the magnetic field contour of the magnetic plate showing the field strength intensity;
Fig. 2A shows an apparatus for storing electrical energy according to an embodiment of the invention;
Fig. 2B ∼ 2E shows localized dipoles of an apparatus for storing electrical energy;
Fig. 3 shows a magnetic capacitor with nano magnets along the inner side of the capacitor plates;
Fig. 4 shows the apparatus while the apparatus is being charged according to an embodiment of the invention;
Fig. 5 shows the apparatus while the apparatus is being discharged according to an embodiment of the invention; and
Fig. 6 shows the apparatus after the apparatus is charged according to an embodiment of the invention.

### DESCRIPTION OF THE PREFERRED EMBODIMENTS

Reference will now be made in detail to the present preferred embodiments of the invention, examples of which are illustrated in the accompanying drawings. Wherever possible, the same reference numbers are used in the drawings and the description to refer to the same or like parts.

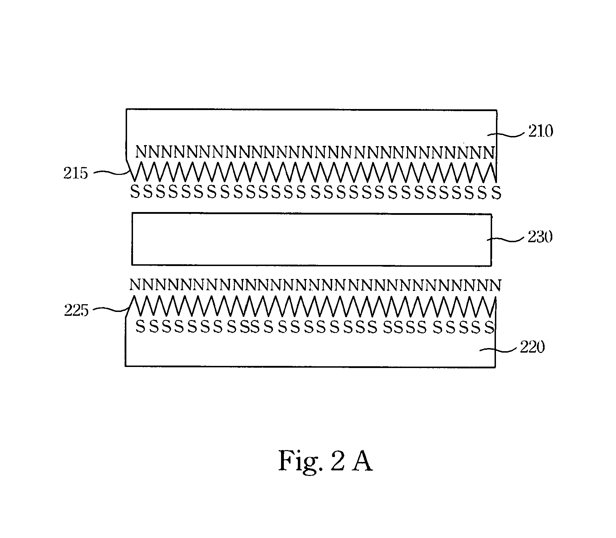

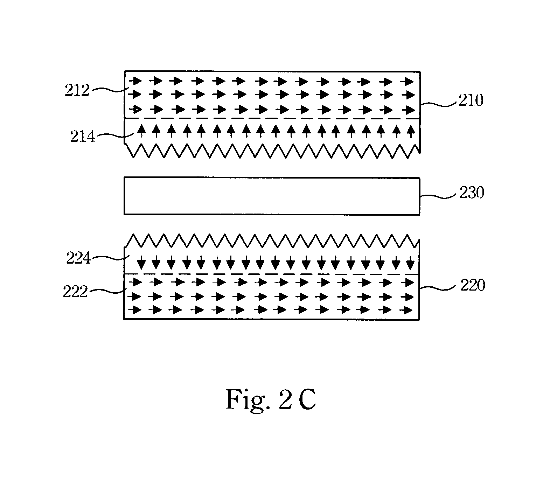

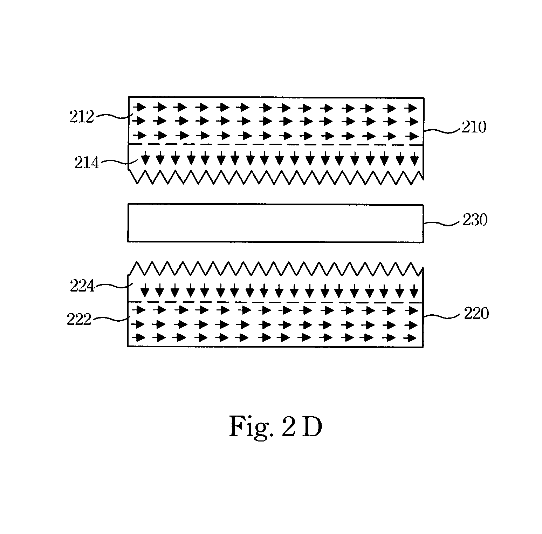

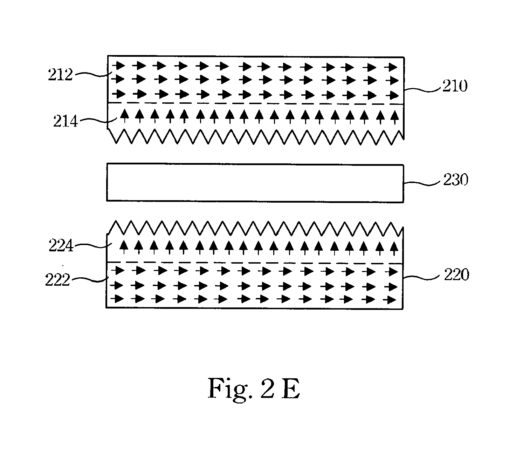

Reference is now made to Fig. 2A, showing an apparatus for storing electrical energy according to an embodiment of the invention. The apparatus for storing electrical energy is a magnetic capacitor. The magnetic capacitor includes a first magnetic layer 210, a second magnetic layer 220, and a dielectric layer 230. The first magnetic layer 210 and the second magnetic layer 220 are both magnetic thin films. The first magnetic layer 210 and the second magnetic layer 220 are made of conductive material. The dielectric layer 230 is made of insulation material, so electric current won't pass through the dielectric layer 230. The dielectric layer 230 is a thin film, and the dielectric layer 230 may be composed of dielectric material, such as BaTiO₃ or TiO₃.

The first magnetic layer 210 has a first surface 215 with saw tooth roughness. The second magnetic layer 220 has a second surface 225 with saw tooth roughness as well. The dielectric layer 230 is configured in between the first magnetic layer 210 and the second magnetic layer 220. The dielectric layer 230 is arranged to store electrical energy. The first magnetic layer 210 and the second magnetic layer 220 are arranged to prevent electrical energy leakage. The saw tooth roughness on the first surface 215 and the second surface 225 may increase the surface area of the first surface 215 and the second surface 225, and thus may increase the capacitance of the magnetic capacitor.

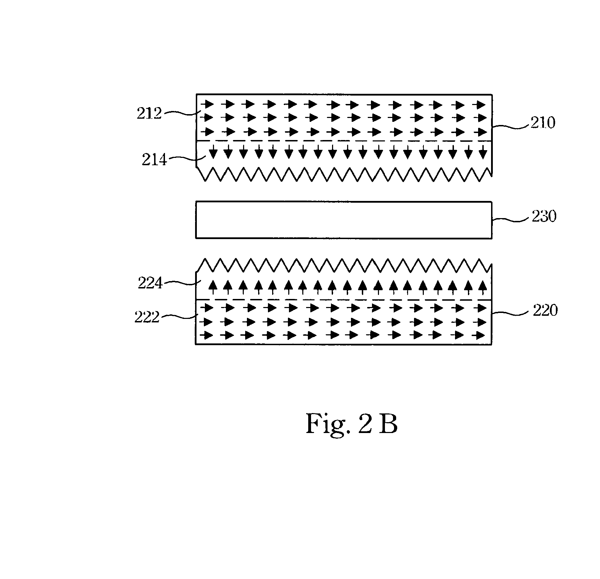

Reference is now made to Fig. 2B, showing localized dipoles of an apparatus for storing electrical energy according to one embodiment of the invention. The first magnetic layer 210 includes a first magnetic section 212 having magnetic dipoles with horizontal directions and a second magnetic section 214 having magnetic dipoles with vertical directions. The second magnetic layer 220 includes a third magnetic section 222 having magnetic dipoles with horizontal directions and a fourth magnetic section 224 having magnetic dipoles with vertical directions. When the apparatus stores electrical energy, the magnetic dipoles of the first magnetic section 212 and the third magnetic section 222 may have the same horizontal directions as shown in the figure.

Namely, when the dipoles of the first magnetic section 212 and the dipoles of the third magnetic section 222 have the same directions, the spin directions of the electrons of the dielectric section 230 point toward one direction. There is no current leakage thereby; thus the energy is stored. It is noted that the symbols '→' are just arranged to represent the dipoles of the magnetic sections, and are not arranged to restrict the dipole directions.

The arrows shown in the first magnetic section 212 and the third magnetic section 222 are parallel to each other. In one aspect of this invention, the arrows shown in the first magnetic section 212 and the third magnetic section 222 are directed along the easy axis. However, it should be noted that when the apparatus stores electrical energy, the dipole directions of the first magnetic section and the dipole directions of the third magnetic section may be parallel to each other (pointing to the same directions) or anti-parallel to each other (pointing to the opposite directions). On the other hand, when the apparatus stores electrical energy, the magnetic dipoles of the second magnetic section 214 are perpendicular to the magnetic dipoles of the first magnetic section 212, and the magnetic dipoles of the fourth magnetic section 224 are perpendicular to the magnetic dipoles of the third magnetic section 222. In one aspect of this invention, the arrows shown in the second magnetic section 214 and the fourth magnetic section 224 are perpendicular to the easy axis. Even though the arrows shown in the second magnetic section 214 and the fourth magnetic section 224 are anti-parallel to each other, it should be noted that the dipole directions in the second magnetic section and the fourth magnetic section of a magnetic capacitor may be anti-parallel to each other (pointing to the opposite directions) or parallel to each other (pointing to the same directions), as shown in Fig. 2B ∼ 2E.

The first magnetic layer 210 may be the first electrode of a magnetic capacitor. The second magnetic layer 220 may be the second electrode of a magnetic capacitor. The first magnetic section 212, second magnetic section 214, third magnetic section 222, and fourth magnetic section magnetic section 224 are conductive sections.

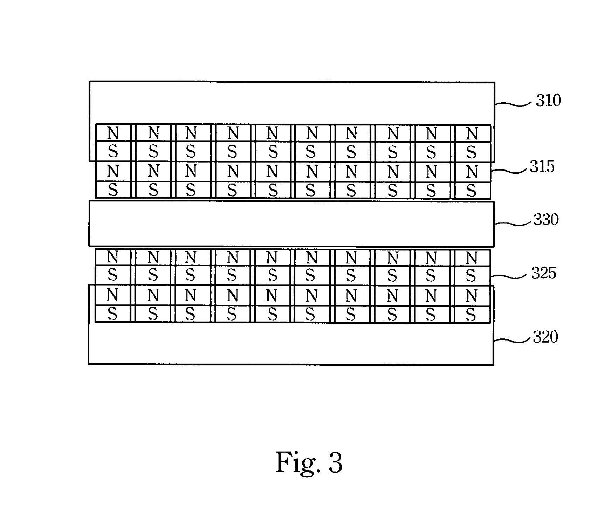

Reference is now made to Fig. 3, showing a magnetic capacitor with nano magnets along the inner side of the capacitor plates. The saw tooth roughness of the magnetic capacitor shown in Fig. 2A has the effect of building up nano magnets 315 and 325 along the inner side of the magnetic plates 310 and 320 shown here. A dielectric layer 330 is configured in between the magnetic plates 310 and 320. Without the existence of nano magnets 315 and 325, the north poles and south poles along the magnetic plates have the strongest magnetic field, and the colossal magnetic effect is reduced from the edge of magnetic plates to the center. The nano magneto effect created by nano magnets 315 and 325 can complement this weakness of magnetic capacitors. Thus, the magnetic field strength of the magnetic capacitor has increased due to the magnetic dipoles with vertical directions.

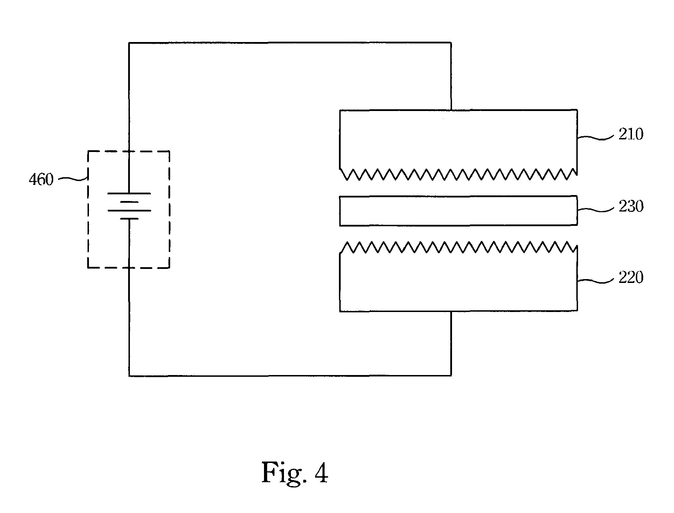

Fig. 4 shows the apparatus while the apparatus is being charged according to an embodiment of the invention. While the apparatus is being charged, the first magnetic layer 210 and the second magnetic layer 220 are coupled to a power source 460. The electrical energy can be inputted into the dielectric layer 230 from the power source 460.

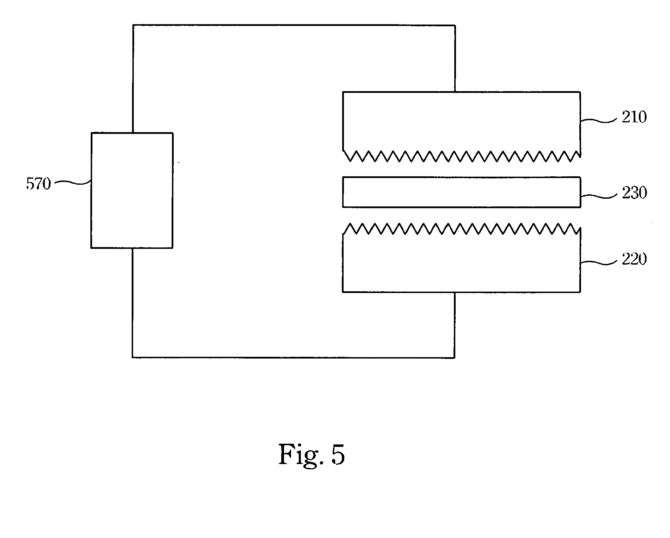

Fig. 5 shows the apparatus while the apparatus is being discharged according to an embodiment of the invention. While the apparatus is being discharged, the first magnetic layer 210 and the second magnetic layer 220 are coupled to a loading device 570. The electrical energy can be outputted from the dielectric layer 230 to the loading device 570.

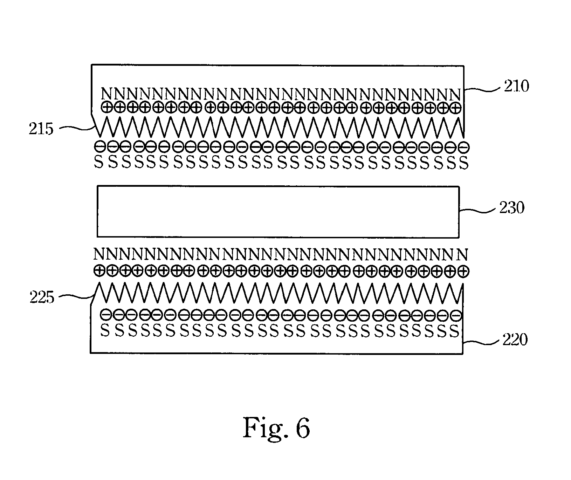

Fig. 6 shows the apparatus after the apparatus is charged according to an embodiment of the invention. When electrodes are applied on both sides of the magnetic capacitor, it will generate electric dipoles on the first surface 215 of the first magnetic layer 210 and the second surface 225 of the second magnetic layer 220 as well. The capacitance will increase in the order of magnitude not only due to the increase of the capacitor area but also due to the increases of magnetic field strength.

In conclusion, the invention provides an apparatus for storing electrical energy. Due to the nano magneto effect on the capacitor plates, the apparatus for storing electrical energy has large capacitance.

## Claims

1. An apparatus for storing electrical energy, comprising:
a first magnetic layer comprising:
a first magnetic section having a plurality of magnetic dipoles with horizontal directions; and
a second magnetic section having a plurality of magnetic dipoles with
vertical directions;
a second magnetic layer comprising:
a third magnetic section having a plurality of magnetic dipoles with horizontal directions; and
a fourth magnetic section having a plurality of magnetic dipoles with vertical directions; and
a dielectric layer configured between the first magnetic layer and the second magnetic layer;

2. The apparatus of claim 1, wherein the magnetic dipoles of the first magnetic section and the magnetic dipoles of the third magnetic section are parallel or anti-parallel to each other when the apparatus stores electrical energy.

3. The apparatus of claim 2, wherein the magnetic dipoles of the second magnetic section are perpendicular to the magnetic dipoles of the first magnetic section and the magnetic dipoles of the fourth magnetic section are perpendicular to the magnetic dipoles of the third magnetic section when the apparatus stores electrical energy.

4. The apparatus of claim 3, wherein the magnetic dipoles of the second magnetic section and the magnetic dipoles of the fourth magnetic section are parallel or anti-parallel to each other when the apparatus stores electrical energy.

5. The apparatus of claim 4, wherein the second magnetic section and the fourth magnetic section have saw tooth roughness.

6. The apparatus of claim 1, wherein while the apparatus is being charged, the first magnetic layer and the second magnetic layer are coupled to a power source.

7. The apparatus of claim 1, wherein while the apparatus is being discharged, the first magnetic layer and the second magnetic layer are coupled to a loading device.

8. An apparatus for storing electrical energy, comprising:
a first magnetic layer comprising:
a first magnetic section; and
a second magnetic section having a plurality of magnetic dipoles with
vertical directions;
a second magnetic layer comprising:
a third magnetic section; and
a fourth magnetic section having a plurality of magnetic dipoles with
vertical directions; and
a dielectric layer configured between the first magnetic layer and the second magnetic layer.

9. The apparatus of claim 8, wherein the magnetic dipoles of the second magnetic section and the magnetic dipoles of the fourth magnetic section are parallel or anti-parallel to each other when the apparatus stores electrical energy.

10. The apparatus of claim 9, wherein the second magnetic section and the fourth magnetic section have saw tooth roughness.

11. The apparatus of claim 1 or 8, wherein the dielectric layer is a thin film.

12. The apparatus of claim 1 or 8, wherein the dielectric layer is composed of dielectric material.

13. The apparatus of claim 1 or 8, wherein the first magnetic layer is a magnetic thin film.

14. The apparatus of claim 1 or 8, wherein the second magnetic layer is a magnetic thin film.

15. An apparatus for storing electrical energy, comprising:
a first electrode comprising:
a first conductive section; and
a second conductive section having a plurality of magnetic dipoles with
vertical directions;
a second electrode comprising:
a third conductive section; and
a fourth conductive section having a plurality of magnetic dipoles with
vertical directions; and
a dielectric layer configured between the first electrode and the second electrode.

## Patentansprüche

1. Vorrichtung zum Speichern elektrischer Energie, die umfasst:
eine erste magnetische Schicht, die umfasst:
einen ersten magnetischen Bereich, der eine Vielzahl an magnetischen Dipolen mit horizontalen Richtungen aufweist; und
einen zweiten magnetischen Bereich, der eine Vielzahl an magnetischen Dipolen mit vertikalen Richtungen aufweist;
eine zweite magnetische Schicht, die umfasst:
einen dritten magnetischen Bereich, der eine Vielzahl an magnetischen Dipolen mit horizontalen Richtungen aufweist; und
einen vierten magnetischen Bereich, der eine Vielzahl an magnetischen Dipolen mit vertikalen Richtungen aufweist; und
eine dielektrische Schicht, die zwischen der ersten magnetischen Schicht und der zweiten magnetischen Schicht ausgebildet ist.

2. Vorrichtung nach Anspruch 1, wobei die magnetischen Dipole des ersten magnetischen Bereichs und die magnetischen Dipole des dritten magnetischen Bereichs parallel oder antiparallel zueinander sind, wenn die Vorrichtung elektrische Energie speichert.

3. Vorrichtung nach Anspruch 2, wobei die magnetischen Dipole des zweiten magnetischen Bereichs rechtwinklig zu den magnetischen Dipolen des ersten magnetischen Bereichs sind und die magnetischen Dipole des vierten magnetischen Bereichs rechtwinklig zu den magnetischen Dipolen des dritten magnetischen Bereichs sind, wenn die Vorrichtung elektrische Energie speichert.

4. Vorrichtung nach Anspruch 3, wobei die magnetischen Dipole des zweiten magnetischen Bereichs und die magnetischen Dipole des vierten magnetischen Bereichs parallel oder antiparallel zueinander sind, wenn die Vorrichtung elektrische Energie speichert.

5. Vorrichtung nach Anspruch 4, wobei der zweite magnetische Bereich und der vierte magnetische Bereich eine Sägezahnrauhigkeit aufweisen.

6. Vorrichtung nach Anspruch 1, wobei, wenn die Vorrichtung geladen wird, die erste magnetische Schicht und die zweite magnetische Schicht an eine Stromquelle angeschlossen sind.

7. Vorrichtung nach Anspruch 1, wobei, wenn die Vorrichtung entladen wird, die erste magnetische Schicht und die zweite magnetische Schicht an eine Ladevorrichtung angeschlossen sind

8. Vorrichtung zum Speichern elektrischer Energie, die umfasst:
eine erste magnetische Schicht, die umfasst:
einen ersten magnetischen Bereich; und
einen zweiten magnetischen Bereich, der eine Vielzahl an magnetischen Dipolen mit vertikalen Richtungen aufweist;
eine zweite magnetische Schicht, die umfasst:
einen dritten magnetischen Bereich; und
einen vierten magnetischen Bereich, der eine Vielzahl an magnetischen Dipolen mit vertikalen Richtungen aufweist; und
eine dielektrische Schicht, die zwischen der ersten magnetischen Schicht und der zweiten magnetischen Schicht ausgebildet ist.

9. Vorrichtung nach Anspruch 8, wobei die magnetischen Dipole des zweiten magnetischen Bereichs und die magnetischen Dipole des vierten magnetischen Bereichs parallel oder antiparallel zueinander sind, wenn die Vorrichtung elektrische Energie speichert.

10. Vorrichtung nach Anspruch 9, wobei der zweite magnetische Bereich und der vierte magnetische Bereich eine Sägezahnrauhigkeit aufweisen.

11. Vorrichtung nach Anspruch 1 oder 8, wobei die dielektrische Schicht eine Dünnschicht ist.

12. Vorrichtung nach Anspruch 1 oder 8, wobei die dielektrische Schicht aus dielektrischem Material besteht.

13. Vorrichtung nach Anspruch 1 oder 8, wobei die erste magnetische Schicht eine magnetische Dünnschicht ist.

14. Vorrichtung nach Anspruch 1 oder 8, wobei die zweite magnetische Schicht eine magnetische Dünnschicht ist.

15. Vorrichtung zum Speichern elektrischer Energie, die umfasst:
eine erste Elektrode, die umfasst:
einen ersten leitenden Bereich; und
einen zweiten leitenden Bereich, der eine Vielzahl an magnetischen Dipolen mit vertikalen Richtungen aufweist;
eine zweite Elektrode, die umfasst:
einen dritten leitenden Bereich, und
einen vierten leitenden Bereich, der eine Vielzahl an magnetischen Dipolen mit vertikalen Richtungen aufweist; und
eine dielektrische Schicht, die zwischen der ersten Elektrode und der zweiten Elektrode ausgebildet ist.

## Revendications

1. Appareil pour stocker de l'énergie électrique comprenant :
une première couche magnétique comprenant :
une première section magnétique ayant une pluralité de dipôles magnétiques avec des directions horizontales et
une seconde section magnétique ayant une pluralité de dipôles magnétiques avec des directions verticales,
une seconde couche magnétique comprenant :
une troisième section magnétique ayant une pluralité de dipôles magnétiques avec des directions horizontales et
une quatrième section magnétique ayant une pluralité de dipôles magnétiques avec des directions verticales et
une couche diélectrique configurée entre la première couche magnétique et la seconde couche magnétique.

2. Appareil selon la revendication 1 dans lequel les dipôles magnétiques de la première section magnétique et les dipôles magnétiques de la troisième section magnétique sont parallèles ou antiparallèles l'un à l'autre lorsque l'appareil stocke de l'énergie électrique.

3. Appareil selon la revendication 2 dans lequel les dipôles magnétiques de la seconde section magnétique sont perpendiculaires aux dipôles magnétiques de la première section magnétique et les dipôles magnétiques de la quatrième section magnétique sont perpendiculaires aux dipôles magnétiques de la troisième section magnétique lorsque l'appareil stocke de l'énergie électrique.

4. Appareil selon la revendication 3 dans lequel les dipôles magnétiques de la seconde section magnétique et les dipôles magnétiques de la quatrième section magnétique sont parallèles ou antiparallèles l'un à l'autre lorsque l'appareil stocke de l'énergie électrique.

5. Appareil selon la revendication 4 dans lequel la seconde section magnétique et la quatrième section magnétique ont une rugosité de dents de scie.

6. Appareil selon la revendication 1 dans lequel, tandis que l'appareil est en train d'être chargé, la première couche magnétique et la seconde couche magnétique sont couplées à une source de courant.

7. Appareil selon la revendication 1 dans lequel, tandis que l'appareil est en train d'être déchargé, la première couche magnétique et la seconde couche magnétique sont couplées à un dispositif de charge.

8. Appareil pour stocker de l'énergie électrique comprenant :
une première couche magnétique comprenant :
une première section magnétique et
une seconde section magnétique ayant une pluralité de dipôles magnétiques avec des directions verticales,
une seconde couche magnétique comprenant :
une troisième section magnétique et
une quatrième section magnétique ayant une pluralité de dipôles magnétiques avec des directions verticales et
une couche diélectrique configurée entre la première couche magnétique et la seconde couche magnétique.

9. Appareil selon la revendication 8 les dipôles magnétiques de la seconde section magnétique et les dipôles magnétiques de la quatrième section magnétique sont parallèles ou antiparallèles l'un à l'autre lorsque l'appareil stocke de l'énergie électrique.

10. Appareil selon la revendication 9 dans lequel la seconde section magnétique et la quatrième section magnétique ont une rugosité de dents de scie.

11. Appareil selon la revendication 1 ou 8 dans lequel la couche diélectrique est un film mince.

12. Appareil selon la revendication 1 ou 8 dans lequel la couche diélectrique est composée de matériau diélectrique.

13. Appareil selon la revendication 1 ou 8 dans lequel la première couche magnétique est un film mince magnétique.

14. Appareil selon la revendication 1 ou 8 dans lequel la seconde couche magnétique est un film mince magnétique.

15. Appareil pour stocker de l'énergie électrique comprenant :
une première électrode comprenant :
une première section conductrice et
une seconde section conductrice ayant une pluralité de dipôles magnétiques avec des directions verticales,
une seconde électrode comprenant :
une troisième section conductrice et
une quatrième section conductrice ayant une pluralité de dipôles magnétiques avec des directions verticales et
une couche diélectrique configurée entre la première électrode et la seconde électrode.
